# EUROPÄISCHE PATENTANMELDUNG

(11) **EP 2 437 319 A2**
(43) Veröffentlichungstag der Anmeldung: **04.04.2012**
(21) Anmeldenummer: 11176265.4
(22) Anmeldetag: 02.08.2011
(51) Int. Cl.: H01L 33/54, H01L 33/48, H01L 33/58

(54) **Verfahren zur Herstellung belinster SMD-Leuchtdioden**

(30) Priorität: 30.09.2010 DE 102010047002
(71) Anmelder: Odelo GmbH, 71409 Schwaikheim (DE)
(72) Erfinder: Manth, Thomas, 52076 Aachen (DE); Kunze, Joe, 47441 Moers (DE); Catic, Samir, 51065 Köln (DE); Olkay, Cem, 58454 Witten (DE)
(74) Vertreter: Benninger, Johannes

(57) **Zusammenfassung**

Es wird ein Verfahren zur Herstellung reflow-lötbarer, belinster SMD-Leuchtdioden (01) beschrieben, mit den Verfahrensschritten:
- zumindest teilweise Umspritzen eines Leadframes (02) mit wenigstens einem Kunststoffkörper (05),
- wobei das Leadframe (02) zumindest eine zur Anordnung und elektrischen Kontaktierung mindestens eines LED-Chips (03) vorgesehene Montagefläche (04) aufweist, und wobei
- der Kunststoffkörper (05) mit wenigstens einer die zumindest eine Montagefläche (04) freihaltende Ausnehmung (06) versehen ist,

- Anordnen und elektrisches Kontaktieren des mindestens einen LED-Chips (03) auf der zumindest einen Montagefläche (04, 10, 11) in der wenigstens einen Ausnehmung (06) und
- Anspritzen zumindest eines wenigstens den verbleibenden Raum der mindestens einen Ausnehmung (06) einnehmenden transparenten Materials (15) als Primäroptik (14) im Anschluss an das Anordnen und elektrische Kontaktieren des wenigstens einen LED-Chips (03) auf der zumindest einen Montagefläche (04, 10, 11).

## Beschreibung

Die Erfindung betrifft ein Verfahren zur Herstellung reflow-lötbarer, belinster SMD-Leuchtdioden mit hoher optischer Effizienz gemäß dem Oberbegriff des Anspruchs 1.

Als Lichtquelle beispielsweise für Leuchten, wie etwa Kraftfahrzeugleuchten, kommen wegen ihres geringen Stromverbrauchs vermehrt Leuchtdioden zum Einsatz. Die Leuchtdioden sind hierbei einzeln oder gruppenweise auf einem mit Leiterbahnen zur elektrischen Kontaktierung versehenen Leuchtmittelträger angeordnet, welcher im Leuchteninnenraum so platziert werden kann, dass das von den Leuchtdioden ausgestrahlte Licht möglichst verlustarm durch wenigstens eine den Leuchteninnenraum abschließende Lichtscheibe hindurch aus der Leuchte austritt.

Eine als Lichtquelle vorgesehene Leuchtdiode besteht zumindest aus wenigstens einem LED-Chip (LED; Lichtemittierende Diode), sowie aus mindestens einem Kontaktmittel zur elektrischen Kontaktierung des LED-Chips. Üblicherweise verfügt jede Leuchtdiode über einen Bonddraht je LED-Chip, welcher je einen LED-Chip elektrisch kontaktiert. Dieser Bonddraht bildet wenigstens ein Kontaktmittel der Leuchtdiode. Der Bonddraht kann mit einem elektrischen Anschluss verbunden sein, welcher zur elektrischen Kontaktierung mit einer Leiterbahn des Leuchtmittelträgers vorgesehen ist. Der LED-Chip selbst ist darüber hinaus beispielsweise über einen zweiten elektrischen Anschluss mit einer zweiten Leiterbahn des Leuchtmittelträgers verbunden. Die Leuchtdiode kann einen den LED-Chip unmittelbar umgebenden Primärreflektor aufweisen. Dieser Primärreflektor kann beispielsweise durch Wandungen einer den LED-Chip umgebenden Ausnehmung und/oder durch einen Napf gebildet sein, in dem der LED-Chip angeordnet ist. Der Napf kann mit dem erwähnten zweiten Anschluss verbunden sein, diesen bilden oder umfassen oder von diesem umfasst werden. Der zweite Anschluss bildet ebenfalls ein Kontaktmittel der Leuchtdiode. Der zweite Anschluss kann jedoch auch entfallen, indem der LED-Chip selbst unmittelbar auf einer ersten Leiterbahn des Leuchtmittelträgers platziert wird. In diesem Fall bildet der mit einer zweiten Leiterbahn verbundene Bonddraht das einzige Kontaktmittel der Leuchtdiode.

Die unterschiedlichen elektrischen Kontaktierungsmöglichkeiten des LED-Chips werden nachfolgend unter Bezugnahme auf die unterschiedlichen, bekannten Ausgestaltungen von Leuchtdioden verdeutlicht.

Bekannt sind Leuchtdioden zur Durchsteckmontage (THT; Through Hole Technology), oberflächenmontierbare (SMD; Surface Mounted Device) Leuchtdioden und Leuchtdioden, bei denen der LED-Chip in Nacktmontagetechnik (COB; Chip On Board) direkt auf den Leuchtmittelträger gebondet wird.

THT-Leuchtdioden sind der gängig bekannte Typ Leuchtdioden. Sie werden auch als bedrahtete Leuchtdioden bezeichnet, da sie aus einer zumindest in einer gewünschten Abstrahlrichtung transparenten Kapselung, z.B. in Form einer Umspritzung oder eines Vergusses bestehen, welche den mit einem Kathodenanschluss verbundenen LED-Chip und einen den LED-Chip mit einem Anodenanschluss verbindenden Bonddraht einschließt. Aus der Kapselung ragen nur die Drähte des Anoden- und des Kathodenanschlusses als die elektrischen Anschlüsse. Der Kathodenanschluss kann hierbei mit einem oben erwähnten Napf versehen sein, in dem der LED-Chip angeordnet ist. Der Bonddraht führt vom Anodenanschluss von außerhalb des Napfs kommend zum LED-Chip.

SMD-Leuchtdioden bestehen aus einem Leadframe mit wenigstens einer Montagefläche für mindestens einen LED-Chip sowie elektrischen Anschlussflächen. Das Leadframe ist von einem Kunststoffkörper mit zumindest einer die wenigstens eine Montagefläche freihaltenden Ausnehmung teilweise umspritzt. Die elektrischen Anschlussflächen des Leadframes sind hierbei zur späteren Oberflächenmontage ebenfalls freigehalten. Der mindestens eine LED-Chip ist am Grund der zumindest einen zur wenigstens einen Montagefläche reichenden Ausnehmung angeordnet und elektrisch kontaktiert. Dabei ist der LED-Chip auf einem mit wenigstens einer ersten elektrischen Anschlussfläche verbundenen ersten elektrischen Anschluss angeordnet. Ein Bonddraht verbindet den LED-Chip mit einem zweiten elektrischen Anschluss, der wiederum mit wenigstens einer zweiten elektrischen Anschlussfläche verbunden ist. Die an ihrem Grund zur Montagefläche reichende Ausnehmung kann reflektorartig ausgestaltet sein. Dabei bilden die Wandungen der Ausnehmung den oben erwähnten Primärreflektor. Hierbei können die Wandungen reflektierend beschichtet sein.

COB-Leuchtdioden bestehen aus einem direkt auf einem Leuchtmittelträger anzuordnenden, ungehäusten LED-Chip und einem Bonddraht. Zur elektrischen Kontaktierung wird der LED-Chip direkt mit einer ersten Leiterbahn eines Leuchtmittelträgers z.B. durch Löten oder Schweißen elektrisch verbunden. Der den zweiten elektrischen Kontakt des LED-Chips bildende Bonddraht wird mit einer zweiten Leiterbahn des Leuchtmittelträgers ebenfalls z.B. durch Löten oder Schweißen elektrisch verbunden.

Um eine je nach Einsatzzweck erwünschte oder beispielsweise gesetzlich vorgegebene Lichtverteilung einer Leuchte mit einer oder mehreren Leuchtdioden als Lichtquelle zu erhalten, kann vorgesehen sein, zumindest einen Teil des von zumindest einer Leuchtdiode ausgestrahlten Lichts zunächst in einen oder mehrere Reflektoren und/oder in einen oder mehrerer Lichtleiter einzustrahlen, beispielsweise um eine Bündelung und/oder eine durch die Lichtscheibe betrachtet gleichmäßigen Helligkeitseindruck zu erzielen.

Darüber hinaus ist bekannt, alternativ oder zusätzlich Linsen unmittelbar vor dem LED-Chip sowie einem gegebenenfalls diesen unmittelbar umgebenden Primärreflektor anzuordnen, um eine in Abhängigkeit von einem vorgegebenen Einsatzzweck erforderliche Lichtverteilung möglichst verlustarm zu erhalten. Derartige in unmittelbarer Nähe zum LED-Chip angeordnete Linsen werden auch als Primäroptiken bezeichnet.

Primäroptiken werden beispielsweise benötigt, um einen Lichtleiter effizient zu nutzen, da bei Lichtleitern im Allgemeinen kollimiertes Licht zur Einkopplung bevorzugt wird. Darüber hinaus sind andere Einsatzzwecke bekannt oder denkbar, bei denen Primäroptiken vorgesehen sind, um andere Lichtverteilungen als z.B. ausschließlich durch Kollimation zu erzeugen.

Eine Leuchtdiode, die mit einer Primäroptik versehen ist, wird im Nachfolgenden als belinste Leuchtdiode bezeichnet.

Um eine belinste THT-Leuchtdiode herzustellen ist bekannt, die Kapselung direkt, beispielsweise während oder nach deren Herstellung im Spritzgießprozess mit einer Primäroptik zu versehen. Durch DE 101 63 117 C1 ist ein Verfahren bekannt, eine belinste THT-Leuchtdiode durch einen zweistufigen Spritzgießprozess herzustellen. Durch DE 10 2004 014 355 B4 ist bekannt, eine belinste THT-Leuchtdiode durch Ur- und Umformen herzustellen.

Belinste THT-Leuchtdioden sind robust beim Umgang während der Lagerung und Montage und weisen eine hohe optische Effizienz auf.

Nachteilig an THT-Leuchtdioden ist deren hoher Montageaufwand bei der Anordnung und elektrischen Kontaktierung auf einem Leuchtmittelträger. Der hohe Montageaufwand ist bedingt durch die Vielzahl gesondert erforderlicher Montageschritte. Zunächst muss das Einfädeln der Drähte des Anoden- und des Kathodenanschlusses in eigens hierfür vorgesehene Öffnungen am Leuchtmittelträger erfolgen. Dann müssen die Drähte des Anoden- und des Kathodenanschlusses durch die Öffnungen hindurch und anschließend auf der Rückseite des Leuchtmittelträgers umgebogen werden, so dass sie auf den entsprechenden Leiterbahnen zum liegen kommen. Anschließend muss die Herstellung der elektrischen Verbindung zwischen den Drähten des Anoden- und des Kathodenanschlusses und den entsprechenden Leiterbahnen auf dem Leuchtmittelträger von der den THT-Leuchtdioden abgewandten Rückseite des Leuchtmittelträgers her beispielsweise durch Verlöten oder Schweißen durchgeführt werden. Darüber hinaus weisen THT-Leuchtdioden einen schlechten Wärmehaushalt auf, bedingt durch deren vollständige und relativ dicke Kapselung. Hierdurch ist ein relativ hoher Wärmegradient vom LED-Chip zur Umgebung nötig, um durch die Kapselung hindurch einen bestimmten Verlustwärmestrom abzugeben.

Durch EP 2 075 856 A2 ist eine belinste SMD-Leuchtdiode bekannt. Die SMD-Leuchtdiode besteht aus einem Leadframe mit einer Montagefläche für einen LED-Chip. Das Leadframe ist zum Teil von einem opaken, spritzgegossenen Kunststoffkörper umhüllt. Der Kunststoffkörper weist an der Oberseite des Leadframes eine Ausnehmung auf, an deren Grund sich die Montagefläche befindet. Die Ausnehmung mit schrägen Wandungen ist vom Leadframe aus gesehen divergent. Eine die Ausnehmung mit dem darin angeordneten LED-Chip abschließende Linse als Primäroptik ist beispielsweise an den schrägen Wandungen der Ausnehmung an dem Kunststoffkörper befestigt. Die Linse kann beispielsweise durch Kleben oder mechanisch am Kunststoffkörper befestigt sein. Die Linse schließt einen in der Ausnehmung verbleibenden, den LED-Chip beherbergenden Aufnahmeraum ab. Zwischen LED-Chip und Linse verbleibt ein einen den LED-Chip beherbergenden Aufnahmeraum bildender Zwischenraum, der zumindest zum Teil mit einer transparenten Masse verfüllt sein kann.

Belinste SMD-LEDs können im Reflow-Verfahren kostengünstig auf einem Leuchtmittelträger montiert werden.

Nachteilig an belinsten SMD-Leuchtdioden nach dem Stand der Technik ist, dass sie wegen der erforderlichen Vielzahl von Verfahrensschritten zur Herstellung der einzelnen Bauteile und dem sich daran anschließenden Zusammenbau der Bauteile zur fertigen belinsten SMD-Leuchtdiode nicht kostengünstige hergestellt werden können.

Darüber hinaus ist eine erwünschte hohe optische Effizienz von derart hergestellten SMD-Leuchtdioden aufgrund der Vielzahl optischer Grenzflächen im Strahlengang vom LED-Chip durch die einen Teil des Zwischenraums zwischen LED-Chip und Linse einnehmenden transparenten Masse hindurch in einen gegebenenfalls verbleibenden, gasbefüllten Teil des Zwischenraums und von diesem zur Linse bis zum Austritt aus derselben heraus nicht gegeben. Ein weiterer Nachteil ergibt sich durch eine ungenaue Positionierung der Primäroptik relativ zum LED-Chip. Die ungenaue Positionierung ergibt sich z.B. durch Toleranzen des Kunststoffkörpers und der Linse sowie durch Toleranzen bei der Positionierung der Linse während des Befestigens am Kunststoffkörper.

Nachteile eines Aufsteckens oder Aufklebens einer Primäroptik auf eine SMD-Leuchtdiode sind außerdem eine relativ große Bauhöhe der Leuchtdiode, was zu einem höheren Bauraumbedarf in der Leuchte führt, einem zusätzlichen und daher teuren Verfahrensschritt zu deren Herstellung, sowie der großen Toleranz bei der Positionierung der Primäroptik und damit geringen Genauigkeit der Abstrahlcharakteristik. Bei Kraftfahrzeugleuchten, bei denen die Leuchtdiode in einem externen Reflektor zur Strahlformung untergebracht ist, wie beispielsweise bei Heckleuchten-Anwendungen vorgesehen, ist aufgrund der geringen Genauigkeit der Abstrahlcharakteristik eine große Bautiefe des externen Reflektors notwendig, um möglichst viel Licht mit dem Reflektor aufzufangen.

Zum Belinsen von COB-Leuchtdioden ist bekannt, den direkt auf den Leuchtmittelträger gebondeten LED-Chip anschließend mit einer transparenten Masse, z.B. einer Silikonmasse oder einem anderen Kunststoff unter anderem zu dessen Schutz zu vergießen. Hierdurch lassen sich jedoch nur einfache Geometrien der Primäroptik herstellen. Durch DE 103 57 818 B4 ist ein Verfahren bekannt, COB-Leuchtdioden gegenüber einem biegesteifen oder biegeweichen Leuchtmittelträger auszurichten und daraufhin thermisch leitend, mechanisch und elektrisch mit dem Leuchtmittelträger und den entsprechend vorgesehenen Leiterbahnen zu verbinden. Im Anschluss hieran wird der Leuchtmittelträger mit der oder den darauf montierten COB-Leuchtdioen in eine Spritzgießform eingebracht. Die Spritzgießform wird dann mit einem nach dem Aushärten transparenten Thermoplast ausgespritzt, der den Leuchtmittelträger durch mindestens einen Durchbruch hindurch durchdringt oder umfließt. Hierdurch lassen sich Geometrien höherer optischer Effizienz verwirklichen, als beim freien Umgießen mit Harz oder Silikon.

Vorteile von COB-Leuchtdioden sind deren hervorragenden thermischen Eigenschaften durch deren im Vergleich mit belinsten THT-Leuchtdioden und belinsten SMD-Leuchtdioden beste Wärmeableitung durch direkten Kontakt des LED-Chips mit dem Leuchtmittelträger.

Nachteilig an COB-Leuchtdioden ist deren insbesondere bis zum Aufbringen einer gegebenenfalls vorgesehenen Vergussmasse hohe Empfindlichkeit bei Lagerung und Umgang, einhergehend mit einem hohen Aufwand zur Qualitätskontrolle nach Montage der COB-Leuchtdioden auf dem Leuchtmittelträger und vor Herstellung der Primäroptik mittels des Vergusses.

Ein Ziel bei der Entwicklung und Herstellung von Kraftfahrzeugkomponenten und - teilen, wie etwa von Leuchtdioden als Lichtquellen für Kraftfahrzeugleuchten, ist eine einfache, zeitsparende und kostengünstige Herstellung, ein einfacher und kostengünstiger Umgang während Lagerung und Montage auf einem Leuchtmittelträger, sowie eine einfache und kostengünstige Montage auf dem Leuchtmittelträger.

Leuchtdioden mit Herstellungs- und/oder Montagekonzepten, welche eine Vielzahl von jeweils zeitaufwändigen Arbeitsschritten zur Herstellung einzelner Bauteile, von mechanischen und/oder elektrischen Verbindungen zwischen einzelnen Bauteilen und/oder Bauteilgruppen oder der Leuchtdioden auf einem Leuchtmittelträger vorsehen, stehen diesem Ziel entgegen.

Eine Aufgabe der Erfindung ist es, ein kostengünstig zu verwirklichendes Verfahren zur Herstellung einer Leuchtdiode zu entwickeln, welche Leuchtdiode eine hohe optische Effizienz aufweist und welche einfach und kostengünstig montiert werden kann und darüber hinaus einfach und unempfindlich in Umgang und Lagerung ist.

Die Aufgabe wird gelöst durch ein Verfahren mit den Merkmalen des unabhängigen Anspruchs 1.

Zur Lösung der Aufgabe sieht die Erfindung demnach ein Verfahren zur Herstellung reflow-lötbarer, belinster SMD-Leuchtdioden vor. Das Verfahren sieht zunächst ein zumindest teilweises Umspritzen eines Leadframes mit einem Kunststoffkörper vor. Das Leadframe weist wenigstens eine zur Anordnung und elektrischen Kontaktierung mindestens eines LED-Chips vorgesehene Montagefläche auf. Das teilweise Umspritzen des Leadframes erfolgt unter Freihaltung zumindest einer an ihrem Grund zu der wenigstens einen Montagefläche reichenden Ausnehmung in dem Kunststoffkörper. Das Verfahren sieht im Anschluss hieran ein Anordnen und elektrisches Kontaktieren des mindestens einen LED-Chips auf der wenigstens einen Montagefläche in der zumindest einen Ausnehmung vor. Daraufhin sieht das Verfahren die Herstellung einer Primäroptik durch Anspritzen eines wenigstens den verbleibenden Raum der zumindest einen Ausnehmung einnehmenden transparenten Materials vor.

Die Geometrie der Primäroptik kann dabei während des Anspritzens des wenigstens den verbleibenden Raum der Ausnehmung einnehmenden transparenten Materials oder im Anschluss hieran, beispielsweise vermittels eines zwei- oder mehrstufigen Spritzgießprozesses und/oder vermittels Ur- und anschließendem Umformen festgelegt werden. Hierbei kann die Primäroptik in jeder beliebigen erforderlichen Geometrie hergestellt werden.

Die Erfindung ermöglicht die Herstellung sämtlicher Freiformoptiken für die Primäroptik. Dadurch wird das vom LED-Chip ausgestrahlte Licht sehr effizient in alle gewünschten und/oder erforderlichen Winkelbereiche ausgestrahlt.

Das zumindest teilweise Umspritzen des Leadframes mit dem Kunststoffkörper erfolgt vorzugsweise unter Freilassung von aus dem Kunststoffkörper ragenden Anschlussflächen des Leadframes für ein späteres Reflow-Löten auf Leiterbahnen eines Leuchtmittelträgers einer Leuchte, z.B. einer Kraftfahrzeugleuchte.

Eine vorteilhafte Ausgestaltung des Verfahrens ergibt sich durch eine Verwendung beliebiger Grundwerkstoffe für das Leadframe, die vorher metallisiert und dadurch elektrisch leitfähig gemacht werden können.

Vor dem zumindest teilweise Umspritzen des Leadframes kann dieses z.B. durch Ausstanzen z.B. aus einem beliebigen Werkstoff und gegebenenfalls anschließendes Metallisieren hergestellt werden.

Das Leadframe kann derart ausgestaltet sein, dass sich direkt unterhalb des LED-Chips eine Metallfläche zur besseren Wärmeableitung bzw. zur wärmetechnischen Anbindung an einen Leuchtmittelträger, beispielsweise eine Platine, befindet.

Das Leadframe kann als Array aus mehreren Einzel-SMD-Leuchtdioden ausgestaltet sein. Hierbei kann ein optionaler weiterer Verfahrensschritt vorgesehen sein, in dem eine Trennung der einzelnen SMD-Leuchtdioden aus dem Leadframe stattfindet.

Das Herstellen des Kunststoffkörpers kann durch teilweise Umspritzen des Leadframes mit einem reflektierenden oder weißen Kunststoff erfolgen. Reflektierender oder weißer Kunststoff verfügt über einen hohen Reflexionsgrad, wodurch eine hohe optische Effizienz eines durch die Wandungen der Ausnehmung gebildeten, den LED-Chip unmittelbar umgebenden Primärreflektors erhalten wird.

Die elektrische Kontaktierung des LED-Chips auf der Montagefläche erfolgt vorzugsweise durch Die- und Wirebonden.

Als das zumindest eine zur Herstellung der Primäroptik durch Anspritzen verwendete, wenigstens den verbleibenden Raum der mindestens einen Ausnehmung einnehmende transparente Material kann beispielsweise ein optisch transparenter Kunststoff, vorzugsweise ein hochtemperaturbeständiges Material mit Eigenschaften eines Thermoplasts, eines thermoplasitschen Elastomers und/oder eines Elastomers, wie beispielsweise ein Silikon verwendet werden.

Beispielsweise ist ein Silikon-Spritzguss zur Verwendung für das transparente Material geeignet.

Das zumindest teilweise Umspritzen des Leadframes mittels des Kunststoffkörpers und das Herstellen der Primäroptik durch Anspritzen eines wenigstens den verbleibenden Raum der zumindest einen Ausnehmung einnehmenden transparenten Materials kann in einer gemeinsamen oder in zwei unterschiedlichen Spritzgießformen eines gemeinsamen oder zweier unterschiedlicher Spritzgießwerkzeuge erfolgen.

Hierzu wird das Leadframe vor dem zumindest teilweise Umspritzen mit dem Kunststoffkörper in eine erste Spritzgießform eingelegt und nach dem zumindest teilweise Umspritzen mit dem Kunststoffkörper aus dieser wieder entnommen, um den LED-Chip auf der Montagefläche anzuordnen und elektrisch zu kontaktieren. Anschließend wird das zumindest teilweise umspritzte Leadframe mit dem auf seiner Montagefläche angeordneten und elektrisch kontaktierten LED-Chip in eine zweite Spritzgießform eingelegt, um die Primäroptik durch Anspritzen des wenigstens den verbleibenden Raum der zumindest einen Ausnehmung einnehmenden transparenten Materials herzustellen.

Eine vorteilhafte Ausgestaltung des Verfahrens sieht eine zumindest Teil-Aushärtung des beispielsweise einen optisch transparenten Kunststoff umfassenden transparenten Materials vor, so lange es sich noch in der Spritzgießform im Spritzgießwerkzeug befindet.

Die zumindest Teil-Aushärtung des optisch transparenten Kunststoffs bzw. Materials kann beispielsweise mittels Wärme oder UV-Licht erfolgen.

Eine andere vorteilhafte Ausgestaltung des Verfahrens sieht eine Nachhärtung des optisch transparenten Kunststoffs bzw. Materials mittels Wärme oder UV-Licht vor. Die Nachhärtung kann nach der Entnahme aus der Spritzgießform oder noch in der Spritzgießform erfolgen.

Das zumindest teilweise von bzw. mit dem Kunststoffkörper umspritzte Leadframe kann zumindest einen Hinterschnitt aufweisen bzw. einen solchen bilden.

Beispielsweise kann der beispielsweise das SMD-Leuchtdioden-Gehäuse bildende Kunststoffkörper zumindest einen Hinterschnitt aufweisen. Der Hinterschnitt ist bevorzugt in der Ausnehmung vorgesehen. Vorzugsweise kann hierzu ein zur Herstellung des Kunststoffkörpers vorgesehenes Spritzgießwerkzeug bzw. eine zur Herstellung des Kunststoffkörpers vorgesehene Spritzgießform mit einem Schieber ausgestaltet sein. Ein Grund für einen Hinterschnitt kann sein, dass bestimmte Abstrahlwinkel nur durch Hinterschnitte z.B. in der Ausnehmung möglich sind bzw. ohne Hinterschnitte nicht im Standardverfahren herstellbar sind. Die Verwendung einer Spritzgießform bzw. eines Spritzgießwerkzeugs mit einem Schieber erlaubt die Herstellung von Hinterschnitten.

Ein alternativer oder zusätzlicher Grund für einen Hinterschnitt kann eine zusätzliche, beispielsweise form- und/oder kraftschlüssige Verbindung zwischen Primäroptik und Kunststoffkörper sein. Beispielsweise kann die Form des Kunststoffkörpers derart ausgestaltet sein, dass das transparente Material mit mindestens einem Hinterschnitt zum z.B. reflektierenden Material des Kunststoffkörpers verkeilt wird. Der Hinterschnitt kann hierbei in der Ausnehmung, beispielsweise an deren Grund oder in einer oder mehreren die Ausnehmung begrenzenden und/oder umgebenden Wandungen, oder an einer anderen Stelle des Kunststoffkörpers vorgesehen sein.

Alternativ oder zusätzlich kann das Leadframe derart zumindest teilweise vom bzw. mit dem Kunststoffkörper umspritzt sein, dass es wenigstens einen Hinterschnitt beispielsweise in der Ausnehmung bildet. Beispielsweise kann das Leadframe in Verbindung mit einer oder mehreren die Ausnehmung begrenzenden Wandungen mindestens einen Hinterschnitt bilden. Ebenso ist denkbar, dass das Leadframe einen den verbleibenden Raum in der Ausnehmung unterteilenden Zwischenboden mit einer oder mehreren Durchgangsöffnungen in der Ausnehmung bildet, durch welche mindestens eine Durchgangsöffnung hindurch das transparente Material der Primäroptik reicht.

Der oder die Anspritzpunkte des Kunststoffkörpers und/oder der durch Anspritzen des wenigstens den verbleibenden Raum der zumindest einen Ausnehmung einnehmenden transparenten Materials hergestellten Primäroptik können derart ausgestaltet und/oder angeordnet sein, dass sie sich nicht an einer optisch aktiven Fläche der beispielsweise eine Linse bildenden Primäroptik oder des durch die Wandungen und den Grund der Ausnehmung gebildeten Primärreflektor befinden. Hierdurch wird die optische Effizienz nochmals gesteigert.

Vorteile der Erfindung gegenüber dem Stand der Technik ergeben sich unter anderem durch eine hohe optische Effizienz der so hergestellten, reflow-lötbaren, belinsten SMD-Leuchtdiode. Dies ist unter anderem durch eine wesentlich genauere Ausrichtung und Positionierung des mit dem Kunststoffkörper zumindest teilweise umspritzten und mit einem auf seiner Montagefläche angeordneten und elektrisch kontaktierten LED-Chip versehenen Leadframes in einer Spritzgießform bzw. Spritzgießwerkzeug möglich, welche zur Herstellung der Primäroptik durch Anspritzen vorgesehen ist. Beim Stand der Technik, bei dem die Primäroptik durch Aufstecken oder ankleben einer Linse hergestellt wird, ist eine derart hohe Genauigkeit nicht gegeben, weshalb durch die Erfindung eine genauere Positioniertoleranz und dadurch eine höhere Präzision der Abstrahlcharakteristik und eine höhere optische Effizienz gegeben ist. Darüber hinaus kann bei der Erfindung die Linse beim Umgang mit ihr nicht beschädigt werden, da ein solcher Umgang nicht vorgesehen ist, da die Primäroptik direkt durch Anspritzen hergestellt wird.

Weitere Vorteile der Erfindung gegenüber dem Stand der Technik ergeben sich dadurch, dass durch die Ausgestaltung als reflow-lötbare SMD-Leuchtdiode die so hergestellte, belinste Leuchtdiode, die eine hohe optische Effizienz vergleichbar einer THT-Leuchtdiode aufweist, einfach, zeit- und kostengünstig z.B. in einem automatischen Bestückungsprozess auf einem Leuchtmittelträger montiert werden kann. Durch das Anspritzen der Primäroptik vorzugsweise in einem Spritzgießprozess im unmittelbaren Anschluss an das Anordnen und elektrische Kontaktieren des LED-Chips auf der Montagefläche ist die so hergestellte, reflow-lötbare, belinste SMD-Leuchtdiode darüber hinaus äußerst unkompliziert und unempfindlich bei Umgang und Lagerung. Die nach dem erfindungsgemäßen Verfahren hergestellte belinste, reflow-lötbare SMD-Leuchtdiode weist demnach sämtliche vorteilhaften Eigenschaften einer THT-Leuchtdiode auf, ohne deren wesentlichen Nachteile bei der Montage aufzuweisen.

Weitere Vorteile ergeben sich dadurch, dass durch das Umspritzen des Leadframes mit dem Kunststoffkörper und durch das anschließende Anspritzen der zumindest den verbleibenden Raum in der Ausnehmung einnehmenden Primäroptik eine vollständige Umhüllung des LED-Chips und des Bonddrahts erhalten wird, und damit eine im weiteren Umgang z.B. während der Qualitätskontrolle, Lagerung und Montage auf einem Leuchtmittelträger stabile Bauform als Chipträger.

Zusätzliche Vorteile ergeben sich durch eine im Vergleich zum Stand der Technik geringe Bauhöhe. Diese wird dank der durch Anspritzen hergestellten Primäroptik erreicht, welche niedriger baut, als eine nach dem Stand der Technik aufgesetzte, z.B. aufgesteckte oder aufgeklebte Primäroptik. Dadurch wird ein nur geringer Bauraum benötigt, was insbesondere bei der Verwendung als Lichtquelle in Kraftfahrzeugleuchten Vorteile aufweist.

Darüber hinaus weist die angespritzte Primäroptik eine höhere optische Effizienz auf, als eine aufgesteckte oder aufgeklebte Primäroptik. Grund hierfür ist unter anderem, dass beim erfindungsgemäßen Anspritzen der Primäroptik das hierfür vorgesehene transparente Material den verbleibenden Raum in der Ausnehmung vollständig einnimmt. Dadurch werden die optische Effizienz nachteilig beeinträchtigende optische Grenzflächen, wie sie beim Stand der Technik zuhauf vorkommen, vermieden.

Weitere Vorteile der Erfindung gegenüber dem Stand der Technik ergeben sich unter anderem durch die Einsparung wenigstens eines Verfahrensschritts bis zur Herstellung der Primäroptik einer fertig belinsten, reflow-lötbaren SMD-Leuchtdiode.

Nachfolgend werden die bis zur Herstellung der Primäroptik erforderlichen Verfahrensschritte nach der Erfindung und anschließend nach dem Stand der Technik betrachtet. Während bis zur Herstellung der Primäroptik einer reflow-lötbaren, belinsten SMD-Leuchtdiode nach dem erfindungsgemäßen Verfahren vereinfacht die Verfahrensschritte:
1. Einlegen des Leadframes in eine erste Spritzgießform,
2. zumindest teilweise umspritzten des Leadframes mit einem Kunststoffkörper in der ersten Spritzgießform,
3. Entnahme des zumindest teilweise mit dem Kunststoffkörper umspritzten Leadframes aus der ersten Spritzgießform,
4. Anordnen und elektrisches Kontaktieren des LED-Chips auf der freigehaltenen Montagefläche des zumindest teilweise mit dem Kunststoffkörper umspritzten Leadframes,
5. Einlegen des zumindest teilweise mit dem Kunststoffkörper umspritzten Leadframes mit dem auf der Montagefläche angeordneten und elektrisch kontaktierten LED-Chip in eine zweite Spritzgießform, und
6. Herstellung der Primäroptik durch Anspritzen eines wenigstens den verbleibenden Raum der zumindest einen Ausnehmung einnehmenden transparenten Materials
ausgeführt werden müssen, sind nach dem Stand der Technik die Verfahrensschritte:
1. Einlegen des Leadframes in eine erste Spritzgießform,
2. zumindest teilweise umspritzten des Leadframes mit einem Kunststoffkörper in der ersten Spritzgießform,
3. Entnahme des zumindest teilweise mit dem Kunststoffkörper umspritzten Leadframes aus der ersten Spritzgießform,
4. Anordnen und elektrisches Kontaktieren des LED-Chips auf der freigehaltenen Montagefläche des zumindest teilweise mit dem Kunststoffkörper umspritzten Leadframes,
5. Spritzgießen einer Linse in einer zweiten Spritzgießform,
6. Entnahme der Linse aus der zweiten Spritzgießform, und
7. Herstellung der Primäroptik durch Anstecken oder Ankleben der Linse in oder über der Ausnehmung
erforderlich. Es ist demnach offensichtlich, dass das erfindungsgemäße Verfahren zusätzlich zu den bereits genannten Vorteilen wie z.B. einer Erzielung einer höheren optischen Effizienz gegenüber dem Stand der Technik die Einsparung eines Verfahrensschritts zur Herstellung der belinsten, reflow-lötbaren SMD-Leuchtdiode ermöglicht. Dies führt zu einer erheblichen Kosten- und Zeitersparnis bei der Herstellung belinster, reflow-lötbarer SMD-Leuchtdioden nach dem erfindungsgemäßen Verfahren im Vergleich zum Stand der Technik.

Ein weiterer Vorteil des erfindungsgemäßen Verfahrens ergibt sich dadurch, dass der letzte beim erfindungsgemäßen Verfahren erforderliche Verfahrensschritt einer Entnahme der fertigen, belinsten, reflow-lötbaren SMD-Leuchtdiode aus der zweiten Spritzgießform gleichzeitig eine Weitergabe der fertigen belinsten, reflow-lötbaren SMD-Leuchtdiode zur weiteren Verwendung, wie z.B. Qualitätskontrolle, Lagerung, Montage auf einem Leuchtmittelträger einer Leuchte erlaubt. Dies ist dadurch bedingt, dass bei der Entnahme die fertig belinsten SMD-Leuchtdiode aus der zweiten Spritzgießform diese bereits in den Händen gehalten wird und damit im selben Zug beispielsweise einer Sammelstelle oder einem Transportband zugeführt werden kann. Beim Stand der Technik wird der letzte Verfahrensschritt durch die Herstellung der Primäroptik durch Anstecken oder Ankleben der Linse in oder über der Ausnehmung gebildet. Eine Weitergabe zur weiteren Verwendung, wie z.B. Qualitätskontrolle, Lagerung, Montage auf einem Leuchtmittelträger einer Leuchte erfordert beim Stand der Technik einen gesonderten Verfahrensschritt.

Nach dem Stand der Technik kann es darüber hinaus erforderlich sein, nach dem Anordnen und elektrischen Kontaktieren des LED-Chips zunächst den LED-Chip und den Bonddraht zu schützen, um diese beim weiteren Umgang, insbesondere bei der Herstellung der Primäroptik, nicht zu beschädigen. Dieses Schützen des LED-Chips und des Bonddrahts erfolgt beispielsweise durch teilweise Verfüllung der Ausnehmung mit einer transparenten Masse. Beim erfindungsgemäßen Verfahren ist ein solcher Verfahrensschritt nicht notwendig, das der Bonddraht und der LED-Chip unmittelbar nach dem Anordnen und elektrischen Kontaktieren des LED-Chips auf der Montagefläche durch die Herstellung der Primäroptik mittels Anspitzen zumindest eines wenigstens den verbleibenden Raum der mindestens einen Ausnehmung einnehmenden transparenten Materials geschützt wird.

Die Erfindung wird nachfolgend anhand von in den Zeichnungen dargestellten Ausführungsbeispielen näher erläutert. Darin bezeichnen gleiche Bezugszeichen gleiche oder gleich wirkende Elemente. Es ist für einen Fachmann vorstellbar, dass Abwandlungen oder Änderungen der Erfindung von den bevorzugten Ausführungsbeispielen gemacht werden können, ohne dabei den Schutzbereich der in der Beschreibung genannten oder in den Ansprüchen geschützten Gegenstände zu verlassen.

Es zeigen in schematischer Darstellung:
- Fig. 1: ein Ablaufdiagramm eines Verfahrens zur Herstellung einer reflow-lötbaren, belinsten SMD-Leuchtdiode.
- Fig. 2: eine perspektivische Ansicht eines Leadframes zur Herstellung einer reflow-lötbaren, belinsten SMD-Leuchtdiode nach einem in Fig. 1 in seinem Ablauf dargestellten Verfahren.
- Fig. 3: eine perspektivische Ansicht eines ersten Ausführungsbeispiels eines zumindest teilweise mit einem Kunststoffkörper umspritzten Leadframes mit einem auf seiner von einer Ausnehmung in dem Kunststoffkörper freigehaltenen Montagefläche angeordneten und elektrisch kontaktierten LED-Chip zur Herstellung einer reflow-lötbaren, belinsten SMD-Leuchtdiode nach einem in Fig. 1 in seinem Ablauf dargestellten Verfahren.
- Fig. 4: ein erstes Ausführungsbeispiel einer nach einem in Fig. 1 in seinem Ablauf dargestellten Verfahren hergestellte SMD-Leuchtdiode in einem Querschnitt.
- Fig. 5: ein zweites Ausführungsbeispiel einer nach einem in Fig. 1 in seinem Ablauf dargestellten Verfahren hergestellte SMD-Leuchtdiode in einer perspektivischen Ansicht.
- Fig. 6: eine perspektivische Ansicht eines zweiten Ausführungsbeispiels eines zumindest teilweise mit einem Kunststoffkörper umspritzten Leadframes mit einer zur Anordnung und elektrischen Kontaktierung eines LED-Chips vorgesehenen, von einer Ausnehmung in dem Kunststoffkörper freigehaltenen Montagefläche zur Herstellung einer reflow-lötbaren, belinsten SMD-Leuchtdiode nach einem in Fig. 1 in seinem Ablauf dargestellten Verfahren.
- Fig. 7: ein drittes Ausführungsbeispiel einer nach einem in Fig. 1 in seinem Ablauf dargestellten Verfahren hergestellte SMD-Leuchtdiode in einer perspektivischen Ansicht.
- Fig. 8: ein viertes Ausführungsbeispiel einer nach einem in Fig. 1 in seinem Ablauf dargestellten Verfahren hergestellte SMD-Leuchtdiode in einer perspektivischen Ansicht.

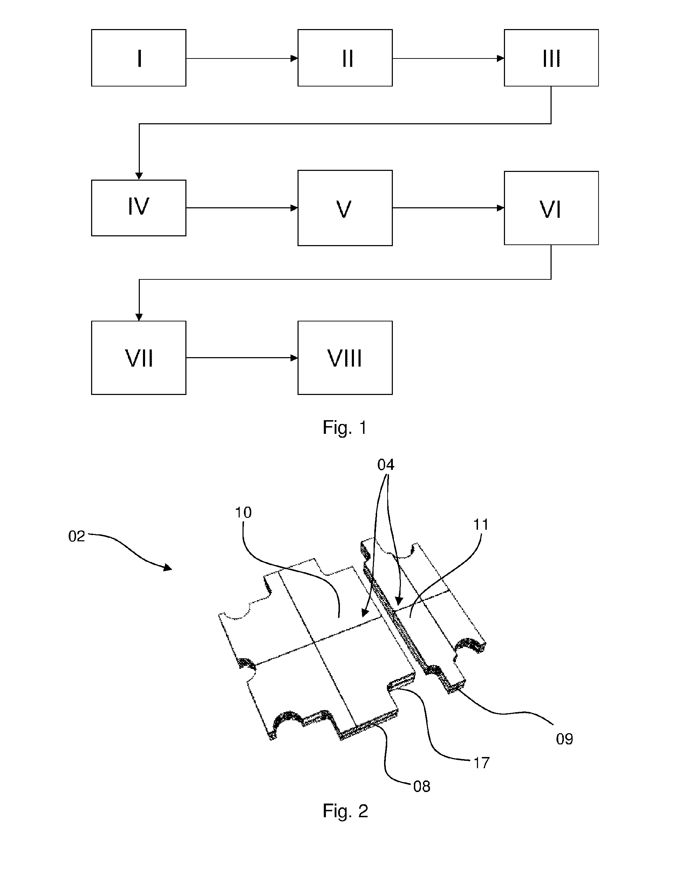

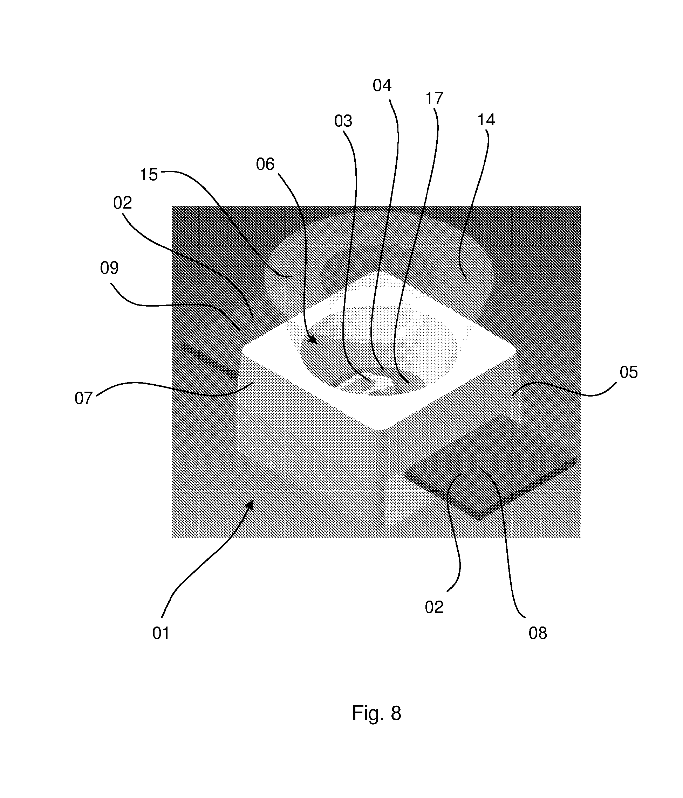

Ein in Fig. 1 schematisch in seinem Ablauf dargestelltes Verfahren zur Herstellung von in den Fig. 2 bis Fig. 8 ganz oder in Teilen dargestellter, reflow-lötbarer, belinster SMD-Leuchtdioden 01 besteht im Wesentlichen aus sieben Verfahrensschritten I, II, III, IV, V, VI, VII.

Das Verfahren startet in einem ersten Verfahrensschritt I mit dem Stanzen eines beispielsweise aus einem beliebigen Werkstoff hergestellten Leadframes 02 (Fig. 2). Ist der Werkstoff, aus dem das Leadframe 02 gestanzt ist, elektrisch nicht oder nur schlecht leitend, so erfolgt vor oder nach dem Stanzen ein metallisieren des Leadframes 02. Das Leadframe 02 weist zumindest eine zur Anordnung und elektrischen Kontaktierung mindestens eines LED-Chips 03 vorgesehene Montagefläche 04 auf. Darüber hinaus weist das Leadframe 02 erste und zweite elektrische Anschlussflächen 08, 09 auf (Fig. 2 bis Fig. 8). Die elektrischen Anschlussflächen 08, 09 sind zur Herstellung einer elektrischen Verbindung der fertigen reflow-lötbaren, belinsten SMD-Leuchtdiode 01 in Oberflächenmontagetechnik mit Leiterbahnen eines Leuchtmittelträgers vorgesehen.

In einem zweiten Verfahrensschritt II findet ein Einlegen des zuvor gestanzten und gegebenenfalls metallisierten Leadframes 02 in eine erste Spritzgießform vorzugsweise eines ersten Spritzgießwerkzeugs statt.

In einem anschließenden dritten Verfahrensschritt III erfolgt ein zumindest teilweises Umspritzen des Leadframes 02 in der ersten Spritzgießform des vorzugsweise ersten Spritzgießwerkzeugs mit einem Kunststoffkörper 05. Der Kunststoffkörper 05 wird dabei mit wenigstens einer beispielsweise an ihrem Grund zu der mindestens einen Montagefläche 04 reichenden und diese freihaltenden Ausnehmung 06 versehen. Die Ausnehmung 06 ist bevorzugt mit vom Leadframe 02 aus gesehen vorzugsweise divergent ausgeführten, schrägen Wandungen 07 versehen. Die elektrischen Anschlussflächen 08, 09 des Leadframes 02 sind hierbei zur späteren Oberflächenmontage ebenfalls freigehalten.

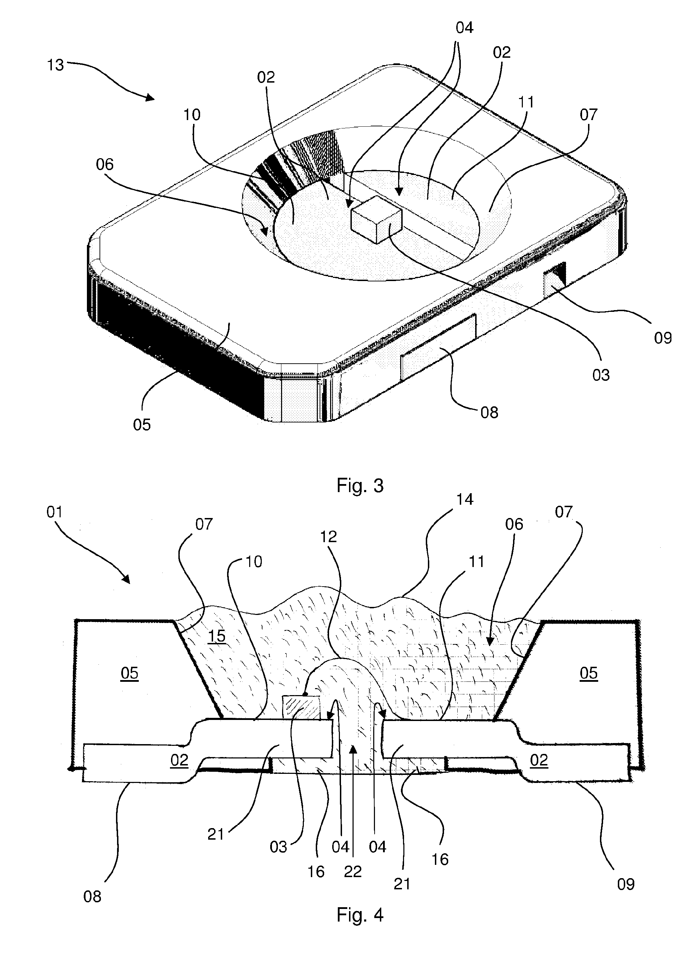

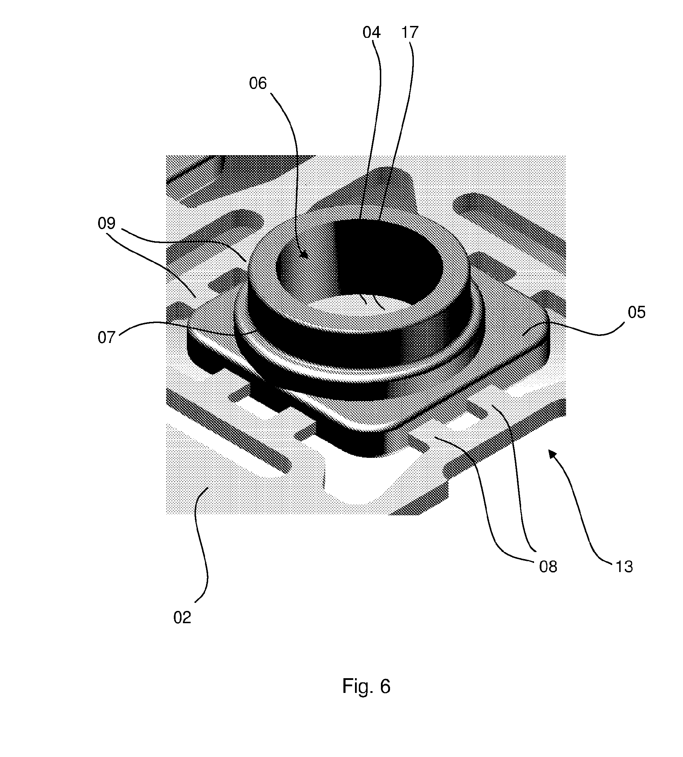

Das vom Kunststoffkörper 05 zumindest teilweise umspritzte Leadframe 02 bildet einen stabilen Chipträger 13 (Fig. 3 und Fig. 6). Mit anderen Worten findet im dritten Verfahrensschritt III ein Spritzgießen eines Chipträgers 13 durch zumindest teilweises Umspritzen des Leadframes 02 mit dem Kunststoffkörper 03 statt. Zur Herstellung des Kunststoffkörpers 05 wird vorzugsweise ein reflektierender oder weißer Kunststoff für das Spritzgießen verwendet. Hierdurch bilden die Wandungen 07 der Ausnehmung 06 des Kunststoffkörpers 05 einen die Montagefläche 04 umgebenden Primärreflektor hoher optischer Güte.

Nach dem dritten Verfahrensschritt III kann der Chipträger 13 bestehend aus dem unter Freilassung wenigstens der Montagefläche 04 vom Kunststoffkörper 05 zumindest teilweise umspritzten Leadframe 02 aus der ersten Spritzgießform des vorzugsweise ersten Spritzgießwerkzeugs entnommen werden, oder für den vierten Verfahrensschritt IV sowie wahlweise für den fünften Verfahrensschritt V in der ersten Spritzgießform des vorzugsweise ersten Spritzgießwerkzeugs verbleiben.

In dem vierten Verfahrensschritt IV erfolgt das Anordnen des LED-Chips 03 auf der Montagefläche 04 mittels Chip- bzw. Die-Bonden. Hierbei wird der LED-Chip 03 derart auf die Montagefläche 04 aufgebracht, dass der LED-Chip 03 auf einem mit wenigstens einer ersten elektrischen Anschlussfläche 08 verbundenen ersten elektrischen Anschluss 10 angeordnet und mit diesem elektrisch verbunden ist. Das Leadframe ist dabei bevorzugt derart ausgestaltet, dass sich direkt unterhalb des LED-Chips 03 eine Metallfläche 17 zur besseren Wärmeableitung befindet.

In dem fünften Verfahrensschritt V erfolgt ein elektrisches Kontaktieren des LED-Chips 03 mit einem zweiten elektrischen Anschluss 11, der wiederum mit wenigstens einer zweiten elektrischen Anschlussfläche 09 verbunden ist. Das elektrische Kontaktieren erfolgt durch Wire-Bonden. Durch das Wire-Bonden wird vermittels eines Bonddrahts 12 eine elektrische Verbindung des LED-Chips 03 mit dem zweiten elektrischen Anschluss 11 hergestellt, der wiederum mit der wenigstens einen zweiten elektrischen Anschlussfläche 09 verbunden ist. Der erste und der zweite elektrische Anschluss sind dabei Teil der Montagefläche 04 bzw. werden von dieser umfasst oder umfassen diese.

Nach dem fünften Verfahrensschritt V kann der mit dem LED-Chip 03 versehene Chipträger 13 sofern dies nicht bereits zwischen dem dritten Verfahrensschritt III und dem vierten Verfahrensschritt IV erfolgt ist, aus der ersten Spritzgießform des vorzugsweise ersten Spritzgießwerkzeugs entnommen werden, und in einem sechsten Verfahrensschritt VI in eine zweite Spritzgießform eines vorzugsweise zweiten Spritzgießwerkzeugs eingelegt werden. Selbstverständlich ist auch denkbar, dass die erste Spritzgießform mit derart ausgestalteten Schiebern versehen ist, dass diese es ermöglichen, die bereits beschriebene Funktion der ersten Spritzgießform zu erfüllen, sowie eine nachfolgend beschriebene Funktion der zweiten Spritzgießform.

In einem siebten Verfahrensschritt VII erfolgt dann im Anschluss an das Anordnen und elektrische Kontaktieren des wenigstens einen LED-Chips 03 auf der zumindest einen Montagefläche 04 eine Herstellung einer Primäroptik 14 durch Anspritzen zumindest eines wenigstens den verbleibenden Raum der mindestens einen Ausnehmung einnehmenden transparenten Materials 15. Das Anspritzen erfolgt dabei in der zweiten Spritzgießform des vorzugsweise zweiten Spritzgießwerkzeugs.

Der Chipträger 13 bzw. dessen Leadframe 02 können mindestens einen Hinterschnitt 16 für das transparente Material 15 der Primäroptik 14 aufweisen bzw. bilden. Alternativ oder zusätzlich kann der Kunststoffkörper 05 des Chipträgers 13 zumindest einen Hinterschnitt 18 für das transparente Material 15 der Primäroptik 14 aufweisen bzw. bilden. Zusammengefasst kann der durch das zumindest teilweise von bzw. mit dem Kunststoffkörper 05 umspritzte Leadframe 02 gebildete Chipträger 13 zumindest einen Hinterschnitt 16, 18 aufweisen bzw. einen solchen bilden.

Der Hinterschnitt 16, 18 ist bevorzugt in der Ausnehmung 06 vorgesehen. Beim Anspritzen des transparenten Materials 15 kann dieses in den Hinterschnitt 16, 18 eindringen, so dass nach dem Aushärten eine zusätzliche form- und/oder kraftschlüssige Verbindung zwischen Primäroptik 14 und Kunststoffkörper 05 und/oder Leadframe 02 besteht. Die Primäroptik 14 wird so in der Ausnehmung 06 beispielsweise verkeilt.

Alternativ oder zusätzlich zu einem Verkeilen kann ein Hinterschnitt 16, 18 als form- und/oder kraftschlüssige Verdrehsicherung der Primäroptik 14 gegenüber dem Kunststoffkörper 05 dienen.

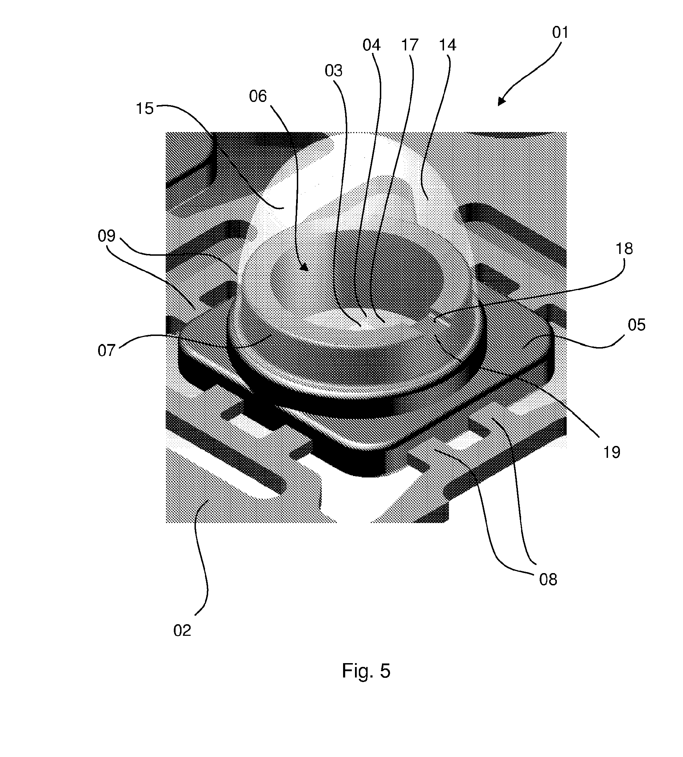

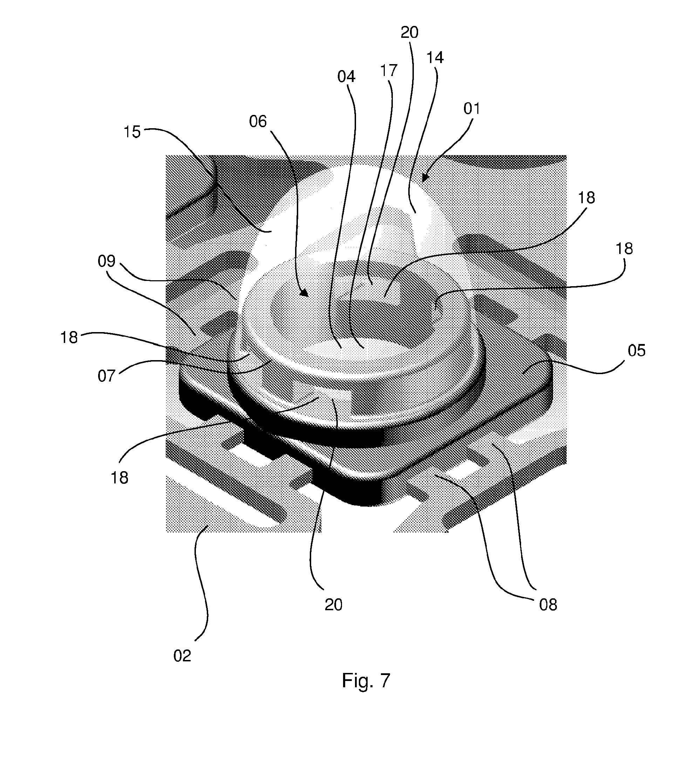

Ein Hinterschnitt 18 kann beispielsweise durch eine Aussparung 19 (Fig. 5) und/oder Öffnung 20 (Fig. 7) in einer Wandung 07 des die Ausnehmung 06 begrenzenden Kunststoffkörpers 05 gebildet sein.

Beispielsweise kann das Leadframe 02 wie in Fig. 4 dargestellt derart zumindest teilweise vom bzw. mit dem Kunststoffkörper 05 umspritzt sein, dass es in der Ausnehmung 06 wenigstens einen Hinterschnitt 16 bildet, indem das Leadframe 02 einen den vom transparenten Material 15 einzunehmenden verbleibenden Raum in der Ausnehmung 06 unterteilenden Zwischenboden 21 mit einer oder mehreren Durchgangsöffnungen 22 in der Ausnehmung 06 bildet, durch welche mindestens eine Durchgangsöffnung 22 hindurch das transparente Material 15 nach dem Anspritzen der Primäroptik 14 reicht.

Bei einem Verbleib des Chipträgers 13 in der Spritzgießform bis zur endgültigen Fertigstellung der belinsten SMD-Leuchtdiode 01 ist denkbar, dass die eine Spritzgießform an unterschiedlichen oder an identischen Spritzgießwerkzeugen bzw. Spritzgießmaschinen eingesetzt wird. Hierdurch wird eine höhere Produktivität der nicht in endloser Anzahl vorhandenen Spritzgießstationen einer Produktionslinie erreicht.

Nach dem siebten Verfahrensschritt VII muss die fertige, belinste SMD-Leuchtdiode nur noch aus der zweiten Spritzgießform entnommen werden.

In einer alternativen Ausgestaltung des Verfahrens findet nach dem siebten Verfahrensschritt VII ein achter Verfahrensschritt VIII statt. Dieser achte Verfahrensschritt VIII sieht vor, dass durch Verwendung eines Leadframearrays mehrere gemeinsam hergestellte, fertige, belinste SMD-Leuchtdioden 01 in einzelne SMD-Leuchtdioden 01 getrennt werden.

Die Erfindung ist insbesondere im Bereich der Herstellung von belinsten SMD-Leuchtdioden als Lichtquellen für Leuchten, wie etwa für Kraftfahrzeugleuchten gewerblich anwendbar.

### Bezugszeichenliste

- 01: SMD-Leuchtdiode
- 02: Leadframe
- 03: LED-Chip
- 04: Montagefläche
- 05: Kunststoffkörper
- 06: Ausnehmung
- 07: Wandung
- 08: erste elektrische Anschlussfläche
- 09: zweite elektrische Anschlussfläche
- 10: erster elektrischer Anschluss
- 11: zweiter elektrischer Anschluss
- 12: Bonddraht
- 13: Chipträger
- 14: Primäroptik
- 15: transparentes Material
- 16: Hinterschnitt
- 17: Metallfläche
- 18: Hinterschnitt
- 19: Aussparung
- 20: Öffnung
- 21: Zwischenboden
- 22: Durchgangsöffnung

- I, II, III, IV, V, VI, VII, VIII: Verfahrensschritte

## Patentansprüche

1. Verfahren zur Herstellung reflow-lötbarer, belinster SMD-Leuchtdioden (01) mit den Verfahrensschritten:
- zumindest teilweise Umspritzen eines Leadframes (02) mit wenigstens einem Kunststoffkörper (05),
- wobei das Leadframe (02) zumindest eine zur Anordnung und elektrischen Kontaktierung mindestens eines LED-Chips (03) vorgesehene Montagefläche (04) aufweist, und wobei
- der Kunststoffkörper (05) mit wenigstens einer die zumindest eine Montagefläche (04) freihaltende Ausnehmung (06) versehen ist; und
- Anordnen und elektrisches Kontaktieren des mindestens einen LED-Chips (03) auf der zumindest einen Montagefläche (04, 10, 11) in der wenigstens einen Ausnehmung (06);
**gekennzeichnet durch** den Verfahrensschritt:
- Herstellung einer Primäroptik (14) im Anschluss an das Anordnen und elektrische Kontaktieren des wenigstens einen LED-Chips (03) auf der zumindest einen Montagefläche (04, 10, 11) **durch** Anspritzen zumindest eines wenigstens den verbleibenden Raum der mindestens einen Ausnehmung (06) einnehmenden transparenten Materials (15).

2. Verfahren nach Anspruch 1,
**gekennzeichnet durch**
eine Festlegung der Geometrie der Primäroptik (14) während des Anspritzens des zumindest einen wenigstens den verbleibenden Raum der mindestens einen Ausnehmung (06) einnehmenden transparenten Materials (15).

3. Verfahren nach Anspruch 1,
**gekennzeichnet durch**
eine Festlegung der Geometrie der Primäroptik (14) im Anschluss an das Anspritzen des zumindest einen wenigstens den verbleibenden Raum der mindestens einen Ausnehmung (06) einnehmenden transparenten Materials (15).

4. Verfahren nach Anspruch 3,
**gekennzeichnet durch**
eine Festlegung der Geometrie der Primäroptik (14) **durch** ein Umformen im Anschluss an ein **durch** das Anspritzen erfolgtes Urformen.

5. Verfahren nach einem der vorhergehenden Ansprüche,
**dadurch gekennzeichnet,**
**dass** das zumindest teilweise Umspritzen des Leadframes (02) mit dem Kunststoffkörper (05) unter Freilassung von aus dem Kunststoffkörper (05) ragenden Anschlussflächen (08, 09) des Leadframes (02) erfolgt.

6. Verfahren nach einem der vorhergehenden Ansprüche,
**dadurch gekennzeichnet,**
**dass** Leadframe (02) durch Ausstanzen hergestellt wird.

7. Verfahren nach einem der vorhergehenden Ansprüche,
**dadurch gekennzeichnet,**
**dass** das Leadframe (02) aus einem beliebigen Material hergestellt wird, welches vor dem zumindest teilweise Umspritzen mit dem wenigstens einen Kunststoffkörper (05) metallisiert wird.

8. Verfahren nach einem der vorhergehenden Ansprüche,
**gekennzeichnet durch**
Verwendung eines reflektierenden oder weißen Kunststoffs für den Kunststoffkörper (05).

9. Verfahren nach einem der vorhergehenden Ansprüche,
**dadurch gekennzeichnet,**
**dass** die elektrische Kontaktierung des LED-Chips (03) auf der Montagefläche (04, 10, 11) durch Die- und Wirebonden erfolgt.

10. Verfahren nach einem der vorhergehenden Ansprüche,
**dadurch gekennzeichnet,**
**dass** das Leadframe (02) derart ausgestaltet ist, dass sich direkt unterhalb des LED-Chips (03) eine Metallfläche (17) zur besseren Wärmeableitung befindet.

11. Verfahren nach einem der vorhergehenden Ansprüche,
**dadurch gekennzeichnet,**
**dass** das Leadframe (02) als Array aus mehreren Einzel-SMD-Leuchtdioden (01) ausgestaltet ist, wobei vor oder nach der Herstellung der Primäroptiken (14) eine Trennung der aus dem einen Leadframe-Array hergestellten, belinsten einzelnen SMD-Leuchtdioden (01) aus dem Leadframe (02) stattfindet.

12. Verfahren nach einem der vorhergehenden Ansprüche,
**dadurch gekennzeichnet,**
**dass** ein durch das zumindest teilweise mit dem Kunststoffkörper (05) umspritzte Leadframe (02) gebildeter Chipträger (13) zumindest einen Hinterschnitt (16, 18) aufweist.

13. Verfahren nach Anspruch 12,
**dadurch gekennzeichnet,**
**dass** das transparente Material (15) mittels des zumindest einen Hinterschnitts (16, 18) mit dem Chipträger (13) form- und/oder kraftschlüssig verbunden wird.

14. Verfahren nach einem der vorhergehenden Ansprüche,
**dadurch gekennzeichnet,**
**dass** der oder die Anspritzpunkte des Kunststoffkörpers (05) und/oder der Primäroptik (14) derart ausgestaltet und/oder angeordnet sind, dass optisch aktive Flächen der Primäroptik (14) oder eines Primärreflektors frei von Anspritzpunkten sind.

15. Verfahren nach einem der vorhergehenden Ansprüche,
**gekennzeichnet durch** die Verfahrensschritte:
- Einlegen des Leadframes (02) in eine erste Spritzgießform,
- zumindest teilweise umspritzten des Leadframes (02) mit einem Kunststoffkörper (05) in der ersten Spritzgießform,
- Entnahme des zumindest teilweise mit dem Kunststoffkörper (05) umspritzten Leadframes (02) (13) aus der ersten Spritzgießform,
- Anordnen und elektrisches Kontaktieren des LED-Chips (03) auf der freigehaltenen Montagefläche (04, 10, 11) des zumindest teilweise mit dem Kunststoffkörper (05) umspritzten Leadframes (02) (13),
- Einlegen des zumindest teilweise mit dem Kunststoffkörper (05) umspritzten Leadframes (02) (13) mit dem auf der Montagefläche (04, 10, 11) angeordneten und elektrisch kontaktierten LED-Chip (03) in eine zweite Spritzgießform, und
- Herstellung der Primäroptik (14) **durch** Anspritzen eines wenigstens den verbleibenden Raum der zumindest einen Ausnehmung (06) einnehmenden transparenten Materials (15).
